# EUROPÄISCHE PATENTSCHRIFT

(11) **EP 1 144 706 B1**
(45) Veröffentlichungstag und Bekanntmachung des Hinweises auf die Patenterteilung: **21.06.2006**
(21) Anmeldenummer: 99924851.1
(22) Anmeldetag: 30.04.1999
(51) Int. Cl.: H01L 21/68

(54) **VERFAHREN UND VORRICHTUNG ZUM THERMISCHEN BEHANDELN VON SUBSTRATEN**
METHOD AND DEVICE FOR THE HEAT TREATMENT OF SUBSTRATES
PROCEDE ET DISPOSITIF DE TRAITEMENT THERMIQUE DE SUBSTRATS

(30) Priorität: 11.05.1998 DE 19821007
(43) Veröffentlichungstag der Anmeldung: 17.10.2001
(73) Patentinhaber: STEAG RTP Systems GmbH, 85551 Kirchheim (DE)
(72) Erfinder: ASCHNER, Helmut, D-89179 Beimerstetten (DE); SCHMID, Patrick, D-89160 Dornstadt (DE); ZERNICKEL, Dieter, D-89079 Ulm (DE)
(74) Vertreter: Wagner, Karl H.
(86) Internationale Anmeldenummer: PCT/EP1999/002942
(87) Internationale Veröffentlichungsnummer: WO 1999/058733

(56) Entgegenhaltungen:
- WO-A-97/06288
- US-A- 4 698 486
- US-A- 4 958 061

## Beschreibung

Die Erfindung betrifft eine Vorrichtung zum thermischen Behandeln von Substraten, insbesondere Halbleiterwafern, mit einer Reaktionskammer und einem Kompensationselement, das den Außenumfang des Substrats umgibt und von ihm beabstandet ist. Die Erfindung betrifft weiterhin ein Verfahren zum thermischen Behandeln von Substraten, insbesondere Halbleiterwafern in einer Reaktionskammer mit einem den Außenumfang des Substrats umgebenden und von diesem beabstandeten Kompensationselement.

Ein Verfahren und eine Vorrichtung dieser Art ist in der DE 36 27 598 C beschrieben. In einer Reaktionskammer der Vorrichtung ist ein Kompensationsring um einen Wafer herum vorgesehen. Der Kompensationsring verhindert während der thermischen Behandlung des Wafers Randeffekte. Mit ihm wird zum Beispiel ein gegenüber dem Innenbereich des Wafers schnelleres Aufheizen am Rand während einer Aufheizphase und ein schnelleres Abkühlen während einer Abkühlphase vermieden. Durch den Kompensationsring werden somit Temperaturinhomogenitäten innerhalb des Wafers unterbunden oder zumindest reduziert. Der Kompensationsrings liegt für eine besonders gute Wirkungsweise, im wesentlichen auf derselben Ebene wie der zu behandelnde Wafer.

In der Vergangenheit wurde der Kompensationsring während des Be- und Entladens des zu behandelnden Substrats zusammen mit diesem ergriffen und ein- bzw. ausgebracht, da eine Handling-Vorrichtung frei auf den Wafer zugreifen konnte.

Dieses gemeinsame Handling von Wafer und Kompensationsring erfordert eine aufwendige Handling-Vorrichtung, die neben einer Wafer-Greifvorrichtung auch eine Kompensationsring-Greifvorrichtung aufweisen muß. Ferner wird durch das gemeinsame Handling die Gefahr einer Beschädigung des Kompensationsrings und/oder des Wafers erhöht.

Aus der US 5,683,518 sowie die JP 10-098048 sind jeweils Vorrichtungen zum thermischen Behandeln von Substraten mit einer Reaktionskammer und einem Kompensationselement bekannt, bei der das Substrat während der thermischen Behandlung auf dem Kompensationselement aufliegt und mit diesem höhenmäßig in der Reaktionskammer bewegt wird. Zum Be- und Entladen werden die Substrate auf Stempeln, welche sich durch das Kompensationselement erstrecken, abgelegt, indem die jeweiligen Kompensationselemente vollständig abgesenkt werden.

Aus der US 4,698,486 ist ebenfalls eine Vorrichtung zum thermischen Behandeln von Substraten mit einer Reaktionskammer und einem Kompensationselement bekannt, bei der das Substrat während der thermischen Behandlung auf dem Kompensationselement aufliegt, und zum Be- und Entladen mit dem Kompensationselement aus der Reaktionskammer herausbewegt wird. Ferner sei auf die US 4,958,062 hingewiesen, welche eine Vorrichtung zur thermischen Behandlung von Substraten mit einer Reaktionskammer und einem Kompensationselement zeigt, bei dem der Boden der Reaktionskammer vertikal bewegbar ist, um die Kammer zu öffnen und zu schließen und ein Be- und Entladen der Substrate zu ermöglichen.

Der Erfindung gemäß den Ansprüchen 1 und 12 liegt daher die Aufgabe zugrunde, ein Verfahren und eine Vorrichtung zum thermischen Behandeln von Substraten anzugeben bzw. zu schaffen mit der bzw. mit dem ein Einbringen und Ausbringen des Wafers in die bzw. aus der Reaktionskammer erleichtert wird.

Ausgehend von der eingangs genannten Vorrichtung wird die gestellte Aufgabe dadurch gelöst, daß das Kompensationselement zumindest teilweise relativ zur Substratebene in der Reaktionskammer schwenkbar ist. Durch zumindest teilweises Verschwenken des Kompensationselementes in der Reaktionskammer wird ein direkter Zugriff einer Handling-Vorrichtung auf den Wafer ermöglicht, da das Kompensationselement aus dem Zugriffsbereich der Handling-Vorrichtung herausschwenkbar ist. Dabei muß nicht notwendigerweise das vollständige Kompensationselement verschwenkt werden, sondern es reicht, es teilweise zu verschwenken, um den freien Zugriff auf den Wafer zu ermöglichen.

Vorteilhafterweise ist für den Kompensationsring oder Teile von ihm eine Schwenkvorrichtung in der Reaktionskammer vorgesehen, so daß von außen keine derartige Vorrichtung eingebracht werden muß.

Gemäß einer bevorzugten Ausführungsform der Erfindung ist die Schwenkvorrichtung im wesentlichen vom Kompensationselement beabstandet und mit ihm mittels wenigstens eines Verbindungselement verbunden. Durch die Beabstandung der Schwenkvorrichtung von dem Kompensationselement wird sichergestellt, daß sie keinen oder nur einen geringen thermischen Einfluß auf das Kompensationselement ausübt.

Vorteilhafterweise weist die Schwenkvorrichtung ein halbkreisförmiges Glied mit einem Innenradius auf, der größer ist als der Außenradius des Kompensationselements, um die thermische Behandlung des Substrats so wenig wie möglich zu beeinflussen. Für einen einfachen Aufbau der Schwenkvorrichtung sind die freien Enden des halbkreisförmigen Gliedes in der Reaktionskammer angebracht.

Gemäß einer weiteren Ausführungsform der Erfindung ist das Kompensationselement selbst schwenkbar gelagert, wodurch sich auf besonders einfache Weise die Schwenkbarkeit ergibt.

Aufgrund der typischen Form der zu behandelnden Substrate ist das Kompensationselement vorzugsweise ein Ringelement. Gemäß einer Ausführungsform besteht das Kompensationselement aus mehreren Segmenten, um die Herstellung des Kompensationselements zu erleichtern. Dies gilt insbesondere für große Substrate, da das Kompensationselement typischerweise aus dem selben Material besteht wie das Substrat und es daher schwierig ist, das Kompensationselement in der erforderlichen Größe einstückig herzustellen. Vorteilhafterweise weisen die Segmente Winkelsegemente von jeweils 60° auf. Für kleinere Substrate sowie für Kompensationselemente, die nicht aus demselben Material wie das zu behandelnde Substrat bestehen, ist das Kompensationselement vorzugsweise einstückig.

Gemäß einer besonders bevorzugten Ausführungsform der Erfindung ist die Schwenkvorrichtung durch Bewegung einer Kammertür der Reaktionskammer steuerbar und insbesondere durch das Öffnen oder Schließen der Kammertür automatisch. Durch automatisches Schwenken mit der Bewegung der Kammertür ergibt sich ein besonders einfacher Betätigungsmechanismus. Durch das automatische Schwenken wird ferner sichergestellt, daß bei geöffneter Kammertür der Zugriff auf den Wafer freigegeben ist.

Ausgehend von dem eingangs genannten Verfahren wird die gestellte Aufgabe erfindungsgemäß auch dadurch gelöst, daß das Kompensationselement zumindest teilweise relativ zur Substratebene in der Reaktionskammer verschwenkt wird, um das Einsetzen und/oder Herausnehmen des Substrats zu erleichtern. Hierdurch ergibt sich wiederum der Vorteil, daß der Zugriff auf das Substrat freigegeben wird und es daher ohne Behinderung ein- und ausgebracht werden kann.

Vorteilhafterweise wird das Kompensationselement automatisch durch Öffnen oder Schließen der Kammertür der Reaktionskammer geschwenkt. Dadurch ist automatisch sichergestellt, daß der Zugriff auf das Substrat bei geöffneter Kammertür freigegeben ist.

Die Erfindung wird nachstehend anhand eines bevorzugten Ausführungsbeispiels unter Bezugnahme auf die Zeichnung erläutert; in der Zeichnung zeigt:
Figur 1 eine perspektivische Ansicht einer Vorrichtung zur thermischen Behandlung von Substraten in teilweiser Querschnittsdarstellung, wobei zur Vereinfachung der Darstellung Teile weggelassen wurden;
Figur 2 eine ähnliche Ansicht zu der Ansicht in Figur 1, wobei ein Kompensationsringsegment in einer abgesenkten Position dargestellt ist;
Figur 3 eine Teilschnittansicht durch eine Vorrichtung gemäß Figur 1 mit einem angehobenen Kompensationsringsegment;
Figur 4 eine vergrößerte Detailschnittansicht, die das Kompensationsringsegment in einer angehobenen Position zeigt;
Figur 5 eine Schnittansicht ähnlich der in Figur 3 dargestelltem Ansicht, wobei das Kompensationsringsegment in einer abgesenkten Position gezeigt ist;
Figur 6 eine vergrößerte Detailschnittansicht, die das Kompensationsringsegment in einer abgesenkten Position zeigt.

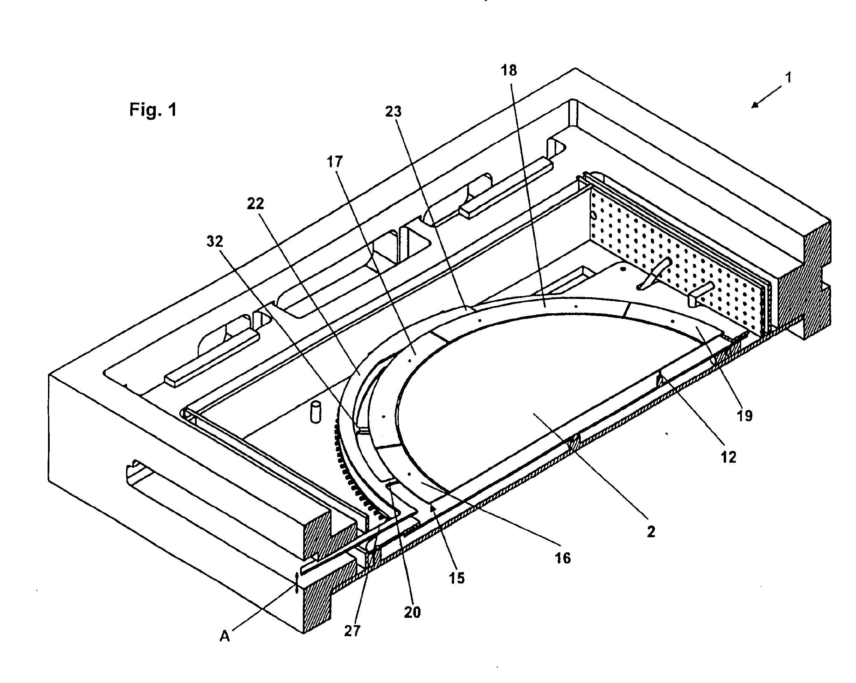

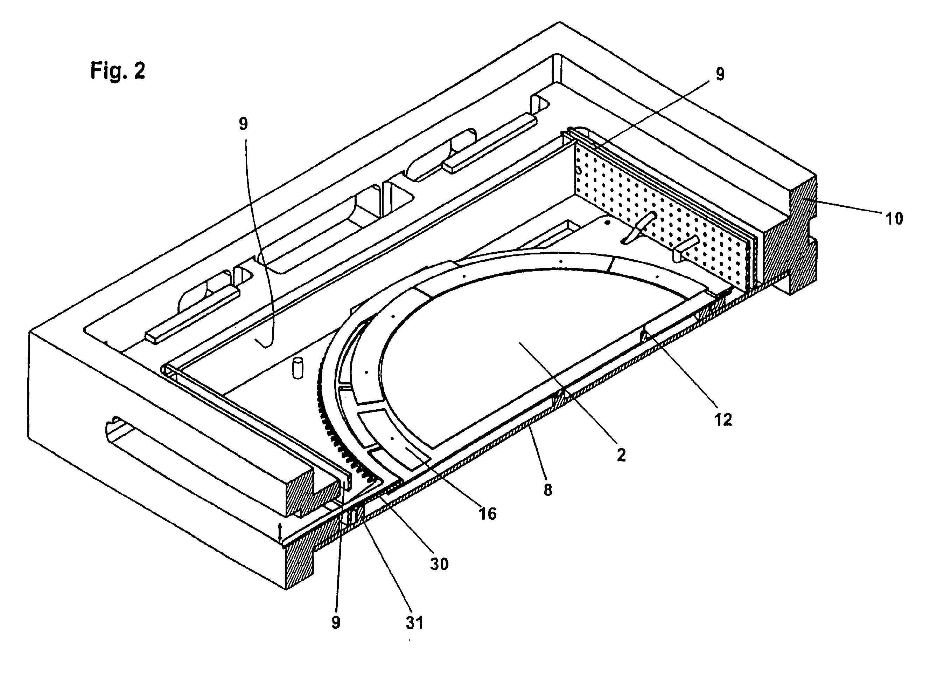

Die Figuren 1 und 2 zeigen eine Vorrichtung 1 zur schnellen thermischen Behandlung von Halbleiterwafern 2. Die Vorrichtung 1 weist eine Reaktionskammer 5 auf, die durch obere und untere Quarzplatten 7, 8 sowie seitliche Auskleidungselemente 9 gebildet wird, die jeweils in einem Gehäuse 10 aufgenommen sind. Zur Erwärmung des Wafers 2 sind nicht dargestellte Strahlungsquellen vorgesehen.

Innerhalb der Reaktionskammer sind mehrere Auflageeinrichtungen 12 vorgesehen, auf denen der Wafer 2 abgelegt wird. Diese Auflageeinrichtungen befinden sich auf einer Rotationsplatte 14, die über eine nicht näher dargestellte Vorrichtung zur Drehung des Wafers angetrieben wird.

Um den Außenumfang des Wafers 2 herum ist ein Kompensationsringelement 15 angeordnet, das in mehrere Segmente 16, 17, 18, 19 aufgeteilt ist. In der Darstellung weisen die Ringsegmente 16, 17, 18, 19 Winkelsegmente von jeweils 60° auf, wobei die Ringsegmente aber auch einen größeren oder kleineren Winkel umschreiben könnten. Obwohl der Kompensationsring segmentiert dargestellt ist, ist es auch möglich, den Kompensationsring einstückig auszubilden.

Über einen Steg 20 ist das Ringsegment 16 mit einem im wesentlichen halbkreisförmigen, schwenkbaren Anheb-/Absenkelement 22 verbunden, dessen freie Enden, wie bei 25 gezeigt ist, schwenkbar in der Reaktionskammer angebracht sind. Von dem schwenkbaren Anheb-/Absenkelement 22 erstreckt sich ein Betätigungshebel 27 zu einer Eingabe-/Ausgabeöffnung in das Gehäuse 10. Dieser Hebel steht mit einer nicht dargestellten Tür der Reaktionskammer in Kontakt und wird durch Öffnen und Schließen der Tür abgesenkt bzw. angehoben, wie dies durch den Doppelpfeil A angedeutet ist.

Die nicht mit dem schwenkbaren Anheb-/Absenkelement 22 verbundenen Ringsegmente 17, 18, 19 liegen auf einem ringförmigen Stützelement 30, das sich auf wenigstens einem Vorsprung 31 der unteren Quarzplatte 8 abstützt und über Stege 32 die Ringsegmente stationär in der Reaktionskammer hält. Das Stützelement 30 ist von der Rotationsplatte 14 beabstandet, so daß die Ringsegmente 17, 18, 19 während der Drehung der Wafer 2. stationär bleiben.

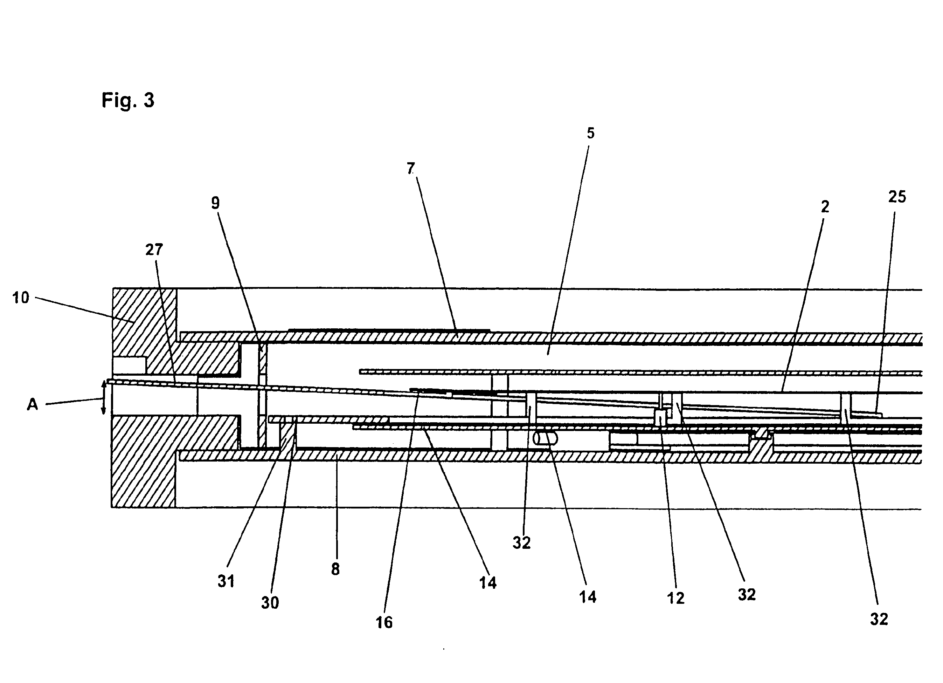

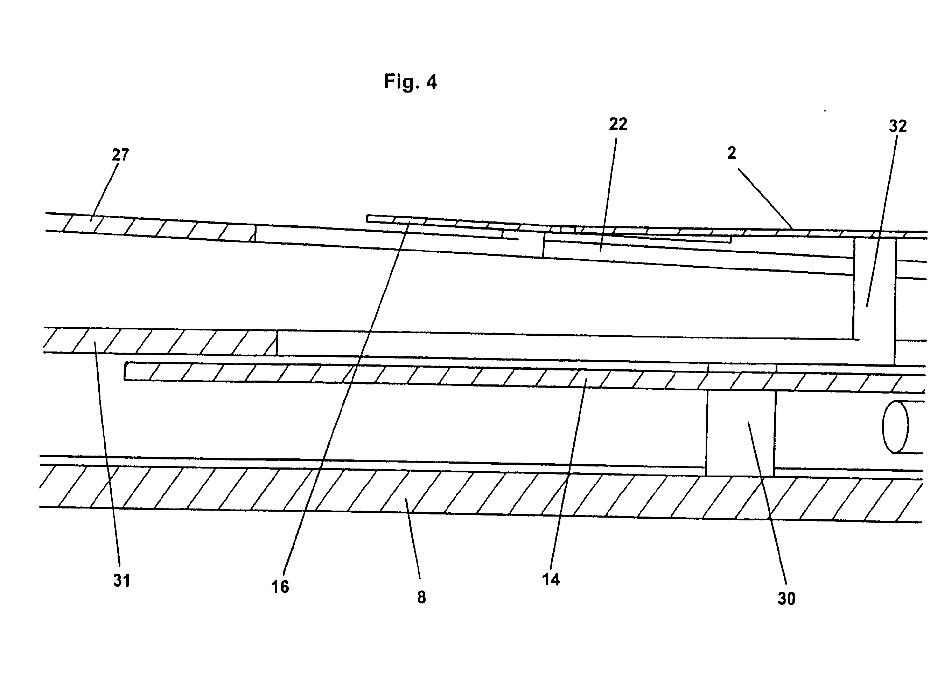

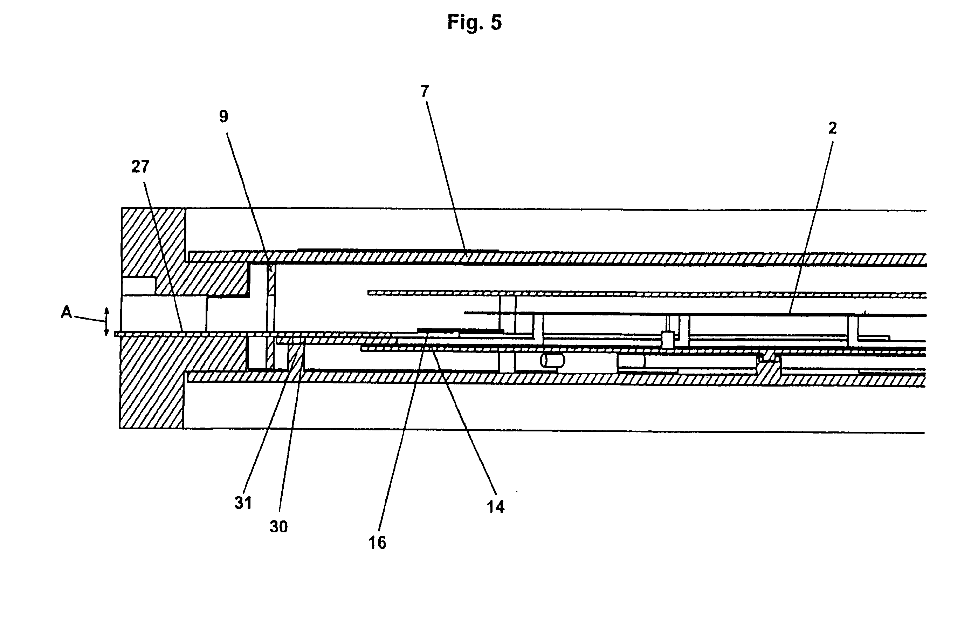

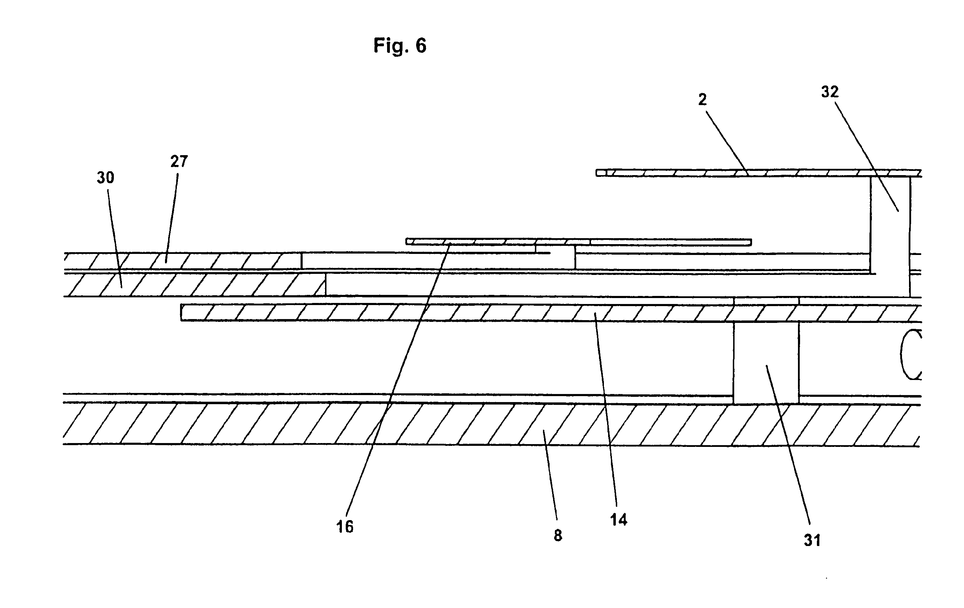

Der Wafer 2 wird für die thermische Behandlung über eine nicht näher dargestellte Handling-Vorrichtung in die Reaktionskammer 5 eingebracht und auf den Auflageelementen 12 abgelegt. Zum Einbringen des Wafers 2 wird das Ringsegment über das schwenkbare Anheb-/Absenkelement 22 durch Verschwenken abgesenkt, wie dies in den Figuren 2, 5 und 6 zu sehen ist, um den Bewegungsbereich der Handling-Vorrichtung freizugeben. Das Schwenken des Anheb/Absenkelementes 22 erfolgt automatisch durch Öffnen der nicht dargestellten Reaktionskammertür, die die Öffnungsbewegung über den Betätigungshebel 22 auf das Anheb-/Absenkelement 22 überträgt. Nach dem Ablegen des Wafers 2 auf den Auflageelementen 12 wird die Handling-Vorrichtung aus der Reaktionskammer herausgezogen und die Reaktionskammertür geschlossen, wodurch sich der Betätigungshebel 22, das Anheb-/Absenkelement 22 und somit das Ringsegment 16 in die in den Figuren 1, 3 und 4 gezeigte Position bewegt. In dieser Position bildet das Ringsegment 16 mit den anderen Ringsegmenten 17, 18, 19 einen im wesentlichen geschlossenen Kompensationsring um den Wafer 2 herum.

In dieser Position wird der Wafer 2 der thermischen Behandlung ausgesetzt. Beim Herausnehmen des Wafers aus der Reaktionskammer 5 wird der vorherige Vorgang umgekehrt.Durch Öffnen der Reaktionskammertür wird das Ringsegment 16 abgesenkt, wodurch der Zugriff durch die Handling-Vorrichtung auf den Wafer 2 freigegeben wird. Die Handling-Vorrichtung ergreift den Wafer 2, und bringt diesen aus der Reaktionskammer 5 heraus. Dann kann ein neuer Wafer 2 wie oben beschrieben, in die Reaktionskammer eingebracht werden.

Die Erfindung wurde zuvor anhand eines bevorzugten Ausführungsbeispiels beschrieben. Dem Fachmann sind jedoch Ausgestaltungen, Modifikationen und Abwandlungen möglich, ohne daß dadurch der Erfindungsgedanke verlassen wird. Insbesondere ist es möglich, das schwenkbare Anheb-/Absenkelement 22 und den Betätigungshebel 27 anders auszugestalten bzw. eine andere Betätigung für diese Elemente vorzusehen. Auch ist es, wie schon oben angedeutet, nicht notwendig, daß der Kompensationsring 15 segmentiert ist. Es ist auch möglich, den Kompensationsring 15 bzw. Segmente desselben schwenkbar in der Reaktionskammer ohne Verwendung eines schwenkbaren Anheb- bzw. Absenkelements anzubringen, wodurch ein separates Anheb-/Absenkelement entfallen könnte und nur ein Betätigungselement für eine Verschwenkung des Kompensationsrings 15 selbst notwendig wäre.

## Patentansprüche

1. Vorrichtung (1) zum thermischen Behandeln von Substraten (2), insbesondere Halbleiterwafern, mit einer Reaktionskammer (5) und einem Temperatur-Kompensationselement (15), das den Außenumfang des Substrats umgibt von ihm beabstandet ist, und im wesentlichen in der Ebene des Substrats liegt, **dadurch gekennzeichnet, daß** das Kompensationselement (15) zumindest teilweise vertikal zur Substratebene in der Reaktionskammer (5) schwenkbar ist.

2. Vorrichtung nach Anspruch 1, **gekennzeichnet durch** eine Schwenkvorrichtung (22, 27) in der Reaktionskammer.

3. Vorrichtung nach Anspruch 2, **dadurch gekennzeichnet, daß** die Schwenkvorrichtung (22, 27) im wesentlichen vom Kompensationselement (15) beabstandet ist und mittels wenigstens einem Verbindungselement (20) mit ihm verbunden ist.

4. Vorrichtung nach einem der Ansprüche 2 oder 3, **dadurch gekennzeichnet, daß** die Schwenkvorrichtung ein halbkreisförmiges Glied (22) mit einem Innenradius aufweist, der größer ist als der Außenradius des Substrats (2).

5. Vorrichtung nach Anspruch 4, **dadurch gekennzeichnet, daß** die freien Enden (23) des halkreisförmigen Gliedes (22) schwenkbar in der Reaktionskammer (5) angebracht sind.

6. Vorrichtung nach einem der vorhergehenden Ansprüche, **dadurch gekennzeichnet, daß** das Kompensationselement (15) schwenkbar in der Reaktionskammer (5) gelagert ist.

7. Vorrichtung nach einem der Ansprüche 2 bis 6, **dadurch gekennzeichnet, daß** die Schwenkvorrichtung (22, 27) durch Bewegung einer Kammertür der Reaktionskammer (5) betätigbar ist.

8. Vorrichtung nach Anspruch 7, **dadurch gekennzeichnet, daß** die Schwenkvorrichtung (22, 27) automatisch durch das Öffnen oder Schließen der Kammertür schwenkbar ist.

9. Vorrichtung nach einem der vorhergehenden Ansprüche, **dadurch gekennzeichnet, daß** das Kompensationselement (15) ein Ringelement ist.

10. Vorrichtung nach einem der vorhergehenden Ansprüche, **dadurch gekennzeichnet, daß** das Kompensationselement (15) aus mehreren Segmenten (16, 17, 18, 19) besteht.

11. Vorrichtung nach Anspruch 10, **dadurch gekennzeichnet, daß** die Segmente ein Winkelsegment von jeweils 60° aufweisen.

12. Verfahren zum thermischen Behandeln von Substraten (2), insbesondere Halblebi-terwafern in einer Reaktionskammer (5) mit eine Temperatur-Kompensationselement (15), das den Außenumfang des Substrats umgibt von ihm beabstandet und im wesentlichen in der Ebene des Substrats liegt, **dadurch gekennzeichnet, daß** das Kompensationselement (15) zum Einsetzen und/oder Herausnehmen des Substrats (2) zumindest teilweise vertikal zur Substratebene in der Reaktionskammer (15) geschwenkt wird, um einen seitlichen Zugriff auf das Substrat freizugeben.

13. Verfahren nach Anspruch 12, **dadurch gekennzeichnet, daß** das Kompensationselement (15) automatisch durch Öffnen oder Schließen einer Kammertür der Reaktionskammer (5) geschwenkt wird.

## Claims

1. An apparatus (1) for the thermal treatment of substrates (2) in particular semiconductors having a reaction chamber (5) and a temperature-compensating element (15) surrounding an outer periphery of the substrate which is spaced therefrom and is essentially disposed in the plane of said substrate, **characterized in that** the compensating element (15) is at least partially vertically pivotable with respect to the substrate plane in the reaction chamber (5).

2. An apparatus according to claim 1, **characterized by** a pivot device (22, 27) in the reaction chamber.

3. An apparatus according to claim 2, **characterized in that** the pivot device (22, 27) is essentially spaced from said compensating element (15) and is connected therewith by means of at least one connection element (20).

4. An apparatus according to one of the claims 2 or 3 **characterized in that** the pivot device comprises a semi-circular member (22) that has an inner radius that is greater than the outer radius of said substrate (2).

5. An apparatus according to claim 4 **characterized in that** the free ends (23) of the semi-circular member (22) are pivotably mounted in said reaction chamber (5).

6. An apparatus according to one of the foregoing claims **characterized in that** the compensating element (15) is pivotably mounted in said reaction chamber (5).

7. An apparatus according to one of the claims 2 to 6 **characterized in that** the pivot device (22, 27) is actuateable by movement of a chamber door of the reaction chamber (5).

8. An apparatus according to claim 7 **characterized in that** the pivot device (22, 27) is automatically pivotable by opening or closing of said chamber door.

9. An apparatus according to one of the foregoing claims **characterized in that** the compensation element (15) is a annular element.

10. An apparatus according to one of the foregoing claims **characterized in that** the compensation element (15) is formed of a plurality of segments (16, 17, 18, 19).

11. An apparatus according to claim 10 **characterized in that** the segments each have an angular segment of 60°.

12. A method for the thermal treatment of substrates (2) in particular semicondutors in a reaction chamber (5) having a temperature-compensation element (15) that surrounds an outer periphery of a substrate and is spaced therefrom, wherein said compensation element is essentially disposed in the plane of said substrate **characterized by** at least partially pivoting said compensation element (15) in said reaction chamber (15) vertically to said plane of said substrate (2) for providing a lateral access to said substrate for introducing or withdrawing said substrate.

13. A method according to claim 12 **characterized by** the step of automatically pivoting said compensation element (15) by opening or closing a door of said reaction chamber (5).

## Revendications

1. Dispositif (1) de traitement thermique de substrats (2), plus particulièrement de tranchées de matériau semi-conducteur, avec une chambre de réaction (5) et un élément de compensation de la température (15), qui entoure le périmètre extérieur du substrat et en est distant, et est situé pour l'essentiel au niveau du substrat, **caractérisé en ce que** l'élément de compensation (15) est apte à pivoter au moins en partie verticalement par rapport au plan du substrat dans la chambre de réaction (5).

2. Dispositif selon la revendication 1, **caractérisé en ce qu'**un dispositif de pivotement (22, 27) est placé dans la chambre de réaction.

3. Dispositif selon la revendication 2, **caractérisé en ce que** le dispositif de pivotement (22, 27) est distant pour l'essentiel de l'élément de compensation (15) et y est relié au moyen d'au moins un élément de raccordement (20).

4. Dispositif selon l'une quelconque des revendications 2 ou 3, **caractérisé en ce que** le dispositif de pivotement comporte un élément semi-circulaire (22) ayant un rayon interne supérieur au rayon externe du substrat (2).

5. Dispositif selon la revendication 4, **caractérisé en ce que** les extrémités libres (23) de l'élément semi-circulaire (22) sont disposées dans la chambre de réaction (5) de façon à pouvoir pivoter.

6. Dispositif selon l'une quelconque des revendications précédentes, **caractérisé en ce que** l'élément de compensation (15) est placé de façon à pouvoir pivoter dans la chambre de réaction (5).

7. Dispositif selon l'une quelconque des revendications 2 à 6, **caractérisé en ce que** le dispositif de pivotement (22, 27) est apte à être actionné suivant le mouvement d'une porte de chambre de la chambre de réaction (5).

8. Dispositif selon la revendication 7, **caractérisé en ce que** le dispositif de pivotement (22, 27) est apte à être pivoté automatiquement par l'ouverture ou la fermeture de la porte de la chambre.

9. Dispositif selon l'une quelconque des revendications précédentes, **caractérisé en ce que** l'élément de compensation (15) est un élément annulaire.

10. Dispositif selon l'une quelconque des revendications précédentes, **caractérisé en ce que** l'élément de compensation (15) comprend plusieurs segments (16, 17, 18, 19).

11. Dispositif selon la revendication 10, **caractérisé en ce que** les segments comportent un segment d'angle d'environ 60 degrés.

12. Procédé de traitement thermique de substrats (2), plus particulièrement de tranches de matériau semi-conducteur, dans une chambre de réaction (5) avec un élément de compensation de la température (15), qui entoure le périmètre extérieur du substrat et en est distant et est situé pour l'essentiel dans le plan du substrat, **caractérisé en ce que** l'élément de compensation (15) est orienté au moins en partie verticalement par rapport au plan du substrat dans la chambre de réaction (5) pour insérer ou enlever le substrat (2), afin de libérer un accès latéral sur le substrat.

13. Procédé selon la revendication 12, **caractérisé en ce que** l'élément de compensation (15) est pivoté automatiquement par l'ouverture ou la fermeture d'une porte de chambre de la chambre de réaction (5).
